# EUROPEAN PATENT APPLICATION

(11) **EP 4 811 987 A1**
(43) Date of publication of application: **23.09.2026**
(21) Application number: 26164718.4
(22) Date of filing: 13.03.2026
(51) Int. Cl.: H10K 59/13, H10K 59/35, H10K 59/80, H10K 59/88

(54) **ELECTRONIC DEVICE**

(30) Priority: 20.03.2025 KR 20250035793
(71) Applicant: Samsung Display Co., Ltd., Yongin-si, Gyeonggi-do (KR)
(72) Inventor: Lee, Dongjin, Yongin-si, Gyeonggi-Do (KR); Yoo, Gi-Na, Yongin-si, Gyeonggi-Do (KR); Kim, Hyomin, Yongin-si, Gyeonggi-Do (KR)
(74) Representative: Gulde & Partner

(57) **Abstract**

Provided is an electronic device (ED) including a display panel (DP) which includes a base layer (BL) including a first region (AA1), a second region (AA2) which surrounds the first region (AA1), and a third region (AA3) which surrounds the second region (AA2), a circuit element layer (D-CL) including transistors (TR) which are included in the pixels (PX) and the IR emitter (IR), a display layer (D-EL) including light-emitting elements (LED, OLED) which are respectively included in the pixels and the IR emitter and are connected to transistors (TR) comprised in the pixels (PX) and the IR emitter (IR), an encapsulation layer (TFE) disposed on the display layer (D-EL), a light control member (OCM) disposed on the encapsulation layer (TFE), and infrared light emitted from the IR emitter is provided such that the infrared light is more similar to a surface light source form in a direction from the third region (AA3) to the first region (AA1).

## Description

### BACKGROUND

The present disclosure herein relates to an electronic device, and more particularly, to an electronic device which includes a display panel including a pixel which emits light having a visible wavelength band and a pixel which emits light having an infrared wavelength band.

An advanced driving assistance system (ADAS) is a high-tech driver assistance system for assisting a driver in driving a vehicle, that is, a system that monitors a situation ahead of a vehicle to obtain information, and determines the situation on the basis of the obtained information in this manner, thereby assisting the driver in driving or controlling the vehicle.

For example, the ADAS detects a driving environment and traffic environment using various sensors, radars, lidars, cameras, or the like, which are mounted on a vehicle to provide the detected information to a driver, or serves as driving assistance by controlling vehicle speed, braking, or the like. As autonomous driving technologies are being developed, it may be desired for a significant number of sensors, radars, lidars, cameras, or the like to be mounted on a vehicle in order to implement a more accurate ADAS.

When a driver wears glasses, light emitted from an infrared (IR) sensor is reflected, which causes errors in information captured by an infrared camera. Therefore, developing a technology for preventing errors in information detected by various sensors and cameras is desired.

### SUMMARY

The present disclosure provides an electronic device which includes a display panel, for a dashboard, or the like, including not only a pixel which emits light having a visible wavelength band but also a pixel which emits light having an infrared wavelength band, and in which light generated from the pixel which emits light having the infrared wavelength band is provided in a simulated surface light source form, thereby improving the accuracy in analyzing driver's pupils and facial muscles even when a driver wears glasses.

An embodiment of the inventive concept provides an electronic device including: a processor configured which provides image data and a display brightness value; a display panel including unit pixels, wherein each of the unit pixels includes pixels which emit light having a visible wavelength band and an infrared (IR) emitter which emits light having an infrared wavelength band; and a panel driver which receives the image data and the display brightness value and drives the display panel based on the image data and the display brightness value, wherein the display panel includes a base layer including a first region, a second region which surrounds the first region, and a third region which surrounds the second region, a circuit element layer including transistors which are included in the pixels and the IR emitter, a display layer including light-emitting elements which are respectively included in the pixels and the IR emitter and are respectively connected to the transistors included in the pixels and the IR emitter, an encapsulation layer disposed on the display layer, a light control member disposed on the encapsulation layer, and infrared light emitted from the IR emitter is provided to be more similar to a surface light source form in a direction from the third region to the first region.

In an embodiment, the light control member may include a first optical layer disposed on the encapsulation layer; may include a second optical layer disposed on the first optical layer; and may include a third optical layer disposed on the second optical layer.

In an embodiment, the first optical layer may include a passivation layer in which openings overlapping the IR emitters and exposing the encapsulation layer are defined; may include first patterns disposed in a first opening which is included among the openings and overlaps the first region; may include a second pattern disposed in a second opening which is included among the openings and overlaps the second region; and may include a third pattern disposed in a third opening which is included among the openings and overlaps the third region.

In an embodiment, the first patterns may include a (1-1)-th pattern and a (1-2)-th pattern which are disposed adjacent to each other, and on a cross section, the (1-1)-th pattern and the (1-2)-th pattern may each have a trapezoidal shape including a first upper surface, a first lower surface which is opposed to the first upper surface, and inclined first side surfaces which connect the first upper surface and the first lower surface.

In an embodiment, on a cross section, the second pattern may have a trapezoidal shape including a second upper surface, a second lower surface which is opposed to the second upper surface, and inclined second side surfaces which connect the second upper surface and the second lower surface.

In an embodiment, on a cross section, the third pattern may have a trapezoidal shape including a third upper surface, a third lower surface which is opposed to the third upper surface, and inclined third side surfaces which connect the third upper surface and the third lower surface.

In an embodiment, among the infrared light emitted from the IR emitter, an amount of light which passes through and is emitted from the side surfaces may increase in the order of a third pattern, a second pattern, and first patterns.

In an embodiment, the light-emitting elements respectively included in the pixels and the IR emitter may each include a first electrode, may each include a second electrode which is disposed on the first electrode, and may each include a light-emitting layer which is disposed between the first electrode and the second electrode, and the display layer may include a pixel-defining film in which display openings exposing at least a portion of the first electrodes are defined.

In an embodiment, on a cross section, a width of the third lower surface may be greater than a width by which the first electrode of the IR emitter disposed in the third region is exposed from the display opening.

In an embodiment, the third side surfaces may each include a first portion through which the infrared light passes, and may each include a second portion through which the infrared light does not pass.

In an embodiment, on a cross section, a sum of widths of the first lower surfaces may be equal to a width by which the first electrode of the IR emitter disposed in the first region is exposed from the display opening.

In an embodiment, on a cross section, a width of the second lower surface may be equal to a width by which the first electrode of the IR emitter disposed in the second region is exposed from the display opening.

In an embodiment, a portion of the second optical layer may be disposed in the openings and may be in contact with the encapsulation layer which is exposed from the first patterns, the second pattern, and the third pattern.

In an embodiment, the passivation layer, the first patterns, the second pattern, and the third pattern may have the same thickness.

In an embodiment, the first optical layer and the second optical layer may include different respective organic materials.

In an embodiment, the first optical layer and the second optical layer may have different respective refractive indices.

In an embodiment, the first optical layer may have a refractive index of about 1.45 to about 1.55, and the second optical layer may have a refractive index of about 1.60 to about 1.70.

In an embodiment, the display panel may further include a dummy region surrounded by the third region and may further include a transmission region surrounded by the dummy region, dummy unit pixels including the pixels and a dummy emitter may be disposed in the dummy region, and transmission unit pixels including the pixels may be disposed in the transmission region.

In an embodiment, the dummy emitter and the IR emitter may have the same structure, and the light-emitting element included in the dummy emitter may not be connected to a transistor included in the dummy emitter.

In an embodiment, the pixels disposed in the unit pixels, the dummy unit pixels, and the transmission unit pixels may have the same arrangement structure.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1A is a block diagram of an electronic device according to an embodiment;
FIG. 1B is a schematic view of each of electronic devices according to various embodiments;
FIG. 1C is a view illustrating an automobile interior in which an electronic device according to an embodiment is disposed;
FIG. 2 is a cross-sectional view of an electronic device according to an embodiment;
FIG. 3A is a plan view of a display surface according to an embodiment of the inventive concept;
FIG. 3B is a plan view of a display surface according to an embodiment of the inventive concept;
FIG. 4 is a cross-sectional view, of an electronic device, taken along line I-I' of FIG. 3A;
FIG. 5 is a plan view of an electronic device included in a vehicle according to an embodiment of the inventive concept;
FIG. 6A is a cross-sectional view of a first region of a cluster according to an embodiment of the inventive concept;
FIG. 6B is a cross-sectional view of a second region of a cluster according to an embodiment of the inventive concept;
FIG. 6C is a cross-sectional view of a third region of a cluster according to an embodiment of the inventive concept;
FIG. 7 is a plan view of an electronic device included in a vehicle according to an embodiment of the inventive concept;
FIG. 8A is a plan view of a region between pixels in a display surface according to an embodiment of the inventive concept;
FIG. 8B is a cross-sectional view of a region between pixels according to an embodiment of the inventive concept; and
FIG. 9 is a plan view of a transmission region in a display surface according to an embodiment of the inventive concept.

### DETAILED DESCRIPTION

In this specification, it will be understood that when an element (or a region, a layer, a portion, or the like) is referred to as being "on", "connected to" or "coupled to" another element, it may be directly disposed on, connected to, or coupled to the other element, or other elements may be disposed therebetween.

Like reference numerals or symbols refer to like elements throughout. In the drawings, the thickness, ratio, and size of the elements are exaggerated for effectively describing the technical contents. As used herein, the term "and/or" includes any and all combinations of one or more of the associated listed elements.

It will be understood that, although the terms "first", "second", and the like may be used herein to describe various elements, the elements are not to be limited by these terms. These terms are used to distinguish one element from another element. For instance, a first element discussed below could be termed a second element without departing from the scope of the inventive concept as defined by the appended claims. Similarly, a second element could be termed a first element. In this specification, the singular expressions "a", "an" and "the" are intended to include the plural forms as well, unless the context clearly indicates otherwise.

In some aspects, the terms "below", "under", "on the lower side", "above", "over", "on the upper side", or the like may be used to describe the relationships between the elements illustrated in the drawings. These terms are relative concepts and are described on the basis of the directions indicated in the drawings.

It will be further understood that the terms "comprises, includes, has" and/or "comprising, including, having", when used in this specification, specify the presence of stated features, numbers, steps, operations, elements, components or combinations thereof, but do not preclude the possibility of the presence or addition of one or more other features, numbers, steps, operations, elements, components, and/or combinations thereof.

The terms "about" or "approximately" as used herein are inclusive of the stated value and include a suitable range of deviation for the particular value as determined by one of ordinary skill in the art, considering the measurement in question and the error associated with measurement of the particular quantity. The terms "about" or "approximately" can mean within one or more standard deviations, or within ± 30%, 20%, 10%, 5% of the stated value, for example.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, embodiments of the inventive concept are described with reference to the drawings.

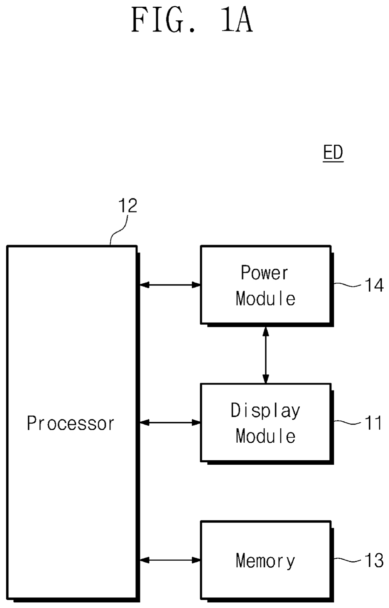

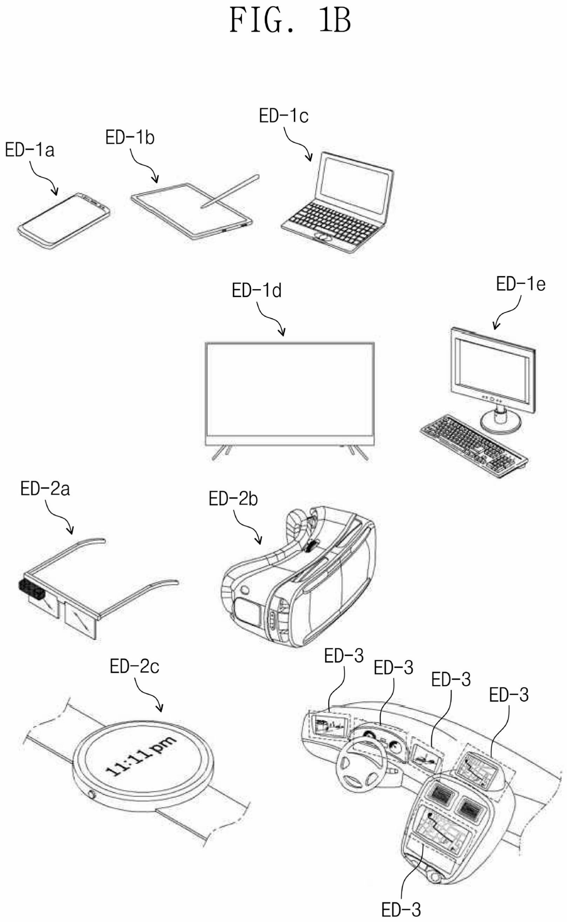

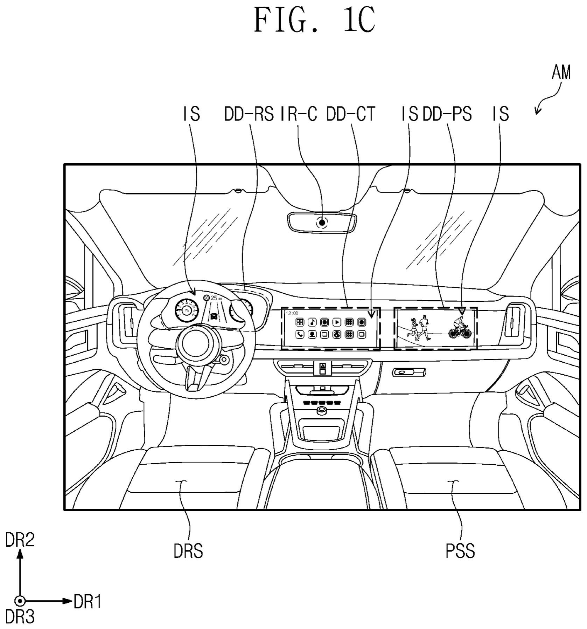

FIG. 1A is a block diagram of an electronic device according to an embodiment. FIG. 1B is a schematic view of each of electronic devices according to various embodiments. FIG. 1C is a view illustrating an automobile interior in which an electronic device according to an embodiment is disposed.

Referring to FIG. 1A, an electronic device ED according to an embodiment may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), or a controller.

The memory 13 may store data information supportive of the operation of the processor 12 or the display module 11. In an example in which the processor 12 executes an application stored in the memory 13, image data signals and/or input control signals are transmitted to the display module 11, and the display module 11 may process the transmitted signals and output image information through a display screen.

The power module 14 may include a power supply module, such as a power adapter or a battery device, and a power conversion module which converts a power supplied by the power supply module to generate a power for an operation of the electronic device ED.

At least one of components of the above-described electronic device ED may be included in a display device according to the above-described embodiments. In some aspects, some of the individual modules which are functionally included in one module may be included in the display device and other modules may also be provided separately from the display device. For example, the display device includes the display module 11, and the processor 12, the memory 13, and the power module 14 may be provided in the form of other devices within the electronic device ED other than the display device.

Referring to FIG. 1B, various electronic devices to which the display device according to embodiments is applied may include an electronic device for displaying images, such as a smart phone ED-1a, a tablet computer ED-1b, a laptop computer ED-1c, a television ED-1d, a desktop monitor ED-1e, and a wearable electronic device including the display module, such as a smart glasses ED-2a, a head mounted display ED-2b, a smart watch ED-2c, as well as an automobile electronic device ED-3 including the display module, such as a center information display (CID) disposed on an instrument panel, a center fascia, or a dashboard of a car, and a room mirror display.

The display device according to an embodiment may be applied to various electronic devices. The electronic device according to an embodiment may include the above-described display device, and further include a module or a device which has additional functions in addition to the display device. FIG. 1C will describe an example of electronic devices DD-RS, DD-CT, and DD-PS included in an automobile AM. The electronic devices DD-RS, DD-CT, and DD-PS to be described in FIG. 1C may correspond to the above-described automobile electronic device ED-3.

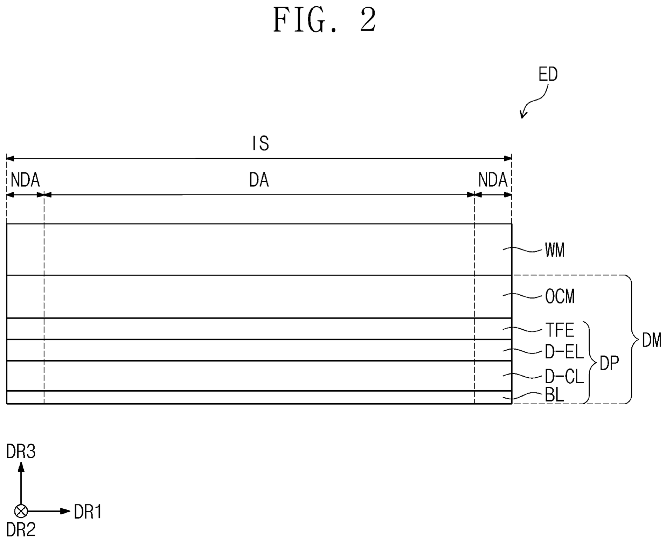

FIG. 1C is a view illustrating an interior of the automobile AM in which a plurality of electronic devices DD-RS, DD-CT, and DD-PS are disposed. The electronic devices DD-RS, DD-CT, and DD-PS disposed inside the automobile AM may correspond to the electronic device ED, according to an embodiment, which will be described in FIG. 2.

The electronic devices DD-RS, DD-CT, and DD-PS according to an embodiment may be disposed inside the automobile AM and provide various information to a user in a driver's seat DRS or a passenger seat PSS. The electronic devices DD-RS, DD-CT, and DD-PS may display images through a display surface IS. The display surface IS on which images are displayed may correspond to a front surface of each of the electronic devices DD-RS, DD-CT, and DD-PS. The images may include not only a dynamic image but also a static image.

The display surface IS may be parallel to each of a first direction DR1 and a second direction DR2. However, embodiments of the present disclosure are not limited thereto, and the display surface IS of each of the electronic devices DD-RS, DD-CT, and DD-PS may include a curved surface designed to reflect the interior of the automobile, or may include a plane defined by the first direction DR1 and the second direction DR2, and an inclined plane. A normal direction of the display surface IS, that is, a thickness direction of each of the electronic devices DD-RS, DD-CT, and DD-PS, is indicated by a third direction DR3.

In FIG. 1C and the following drawings, the first direction axis DR1 to a third direction axis DR3 are illustrated, and directions indicated by the first to third direction axes DR1, DR2, and DR3 described herein may have a relative concept, and thus may be changed to other directions. In some aspects, the directions indicated by first to third direction axes DR1, DR2, and DR3 may be referred to as the first to third directions DR1, DR2, and DR3, and may be denoted as the same reference numerals or symbols. In this specification, the first direction DR1 and the second direction DR2 may be orthogonal to each other, and the third direction DR3 may be a normal direction of a plane defined by the first direction DR1 and the second direction DR2.

In this specification, the first direction DR1 may be referred to as a left-right direction, the second direction DR2 may be referred to as an up-down direction, and the third direction DR3 may be referred to as a thickness direction.

A front surface (or an upper surface) and a rear surface (or a lower surface) of each of members configuring the electronic devices DD-RS, DD-CT, and DD-PS may be opposed to each other in the third direction DR3, and the normal direction of each of the front surface and the rear surface may be substantially parallel to the third direction DR3. A spacing distance between the front surface and the rear surface defined along the third direction DR3 may correspond to a thickness of a member.

In some aspects, in this specification, the wording "on a plane" may be defined as a state when viewed in the third direction DR3. In this specification, the wording "on a cross section" may be defined as a state when viewed in the first direction DR1 or the second direction DR2.

On a plane, the display surface IS included in each of the electronic devices DD-RS, DD-CT, and DD-PS may have various shapes according to a design of the automobile AM.

Referring to FIG. 1C, a first electronic device DD-RS (corresponding to a typical car dashboard) may be disposed at a position facing the driver's seat DRS. In the first electronic device DD-RS, components related to not only information associated with driving, such as vehicle status information, vehicle internal operation information, and navigation information, but also a vehicle control system which operates during autonomous driving may be disposed.

For example, the first electronic device DD-RS according to an embodiment may include a display panel DP including a pixel which emits light having a visible wavelength band (usually refers to wavelengths the human eye can perceive (visible light), e.g., wavelengths between around 380 nm and around 750 nm) and a pixel which emits light having an infrared wavelength band (usually refers to wavelengths longer than those of visible light but shorter than those of microwaves, e.g., wavelengths between around 800 nm and around 2.5 µm). Since infrared light is incident onto driver's pupils and the incident infrared light is re-reflected, driver's pupils and facial muscles may be analyzed via an infrared camera IR-C. This makes it possible to monitor driver's status during autonomous driving in real-time, thereby preventing drowsy driving.

The infrared camera IR-C according to an embodiment may be embedded into a back mirror. However, embodiments of the present disclosure are not limited thereto, and the infrared camera IR-C may be disposed on a dashboard adjacent to the driver's seat DRS, or may be disposed below the first electronic device DD-RS overlapping the first electronic device DD-RS. The details thereof will be described later.

A second electronic device DD-PS may be disposed at a position facing the passenger seat PSS. The second electronic device DD-PS may display not only information associated with driving, such as vehicle status information, vehicle internal operation information, and navigation information, but also various information unrelated to driving.

According to an embodiment, the second electronic device DD-PS may also include the display panel DP including a pixel which emits light having a visible wavelength band and a pixel which emits light having an infrared wavelength band. This makes it possible to monitor a passenger's status during autonomous driving in real-time.

A third electronic device DD-CT may be a center information display (CID). The third electronic device DD-CT may be mounted on a dashboard between the driver's seat DRS and the passenger seat PSS. The third electronic device DD-CT may display various information in an integrated manner to a user of the driver's seat DRS or the passenger seat PSS. According to an embodiment, the third electronic device DD-CT may also include the display panel DP including a pixel which emits light having a visible wavelength band and a pixel which emits light having an infrared wavelength band, but is not limited to any one embodiment.

FIG. 2 is a cross-sectional view of an electronic device according to an embodiment. An electronic device ED may include a display module DM and a window module WM disposed on the display module DM. The display module DM may include a display panel DP and a light control member OCM. The electronic device ED to be described herein may correspond to any one among the above-descried electronic devices DD-RS, DD-CT, and DD-PS.

The window module WM may be disposed on the display module DM and cover the entire upper surface of the display module DM. A front surface of the window module WM may define a display surface IS of the electronic device ED. The shape of the window module WM may correspond to the shape of the display module DM.

The window module WM may include a substrate or a film which includes glass or a polymer material. In some aspects, the window module WM may further include a functional layer, such as a protective film, disposed on a substrate or film which serves as a base. An adhesive layer may bond the window module WM and the light control member OCM. The adhesive layer may be an optically clear adhesive layer (OCA). In an embodiment, the window module WM may also be omitted.

The display panel DP may include a base layer BL, a circuit element layer D-CL, a display layer D-EL, and an encapsulation layer TFE. The display panel DP may be a component for substantially generating an image.

The display panel DP included in the electronic device ED according to an embodiment may be an organic light-emitting display panel, an inorganic light-emitting display panel, an organic-inorganic light-emitting display panel, a quantum dot display panel, a micro LED display panel, a nano LED display panel, and the like. In this example embodiment, the display panel DP is described as an organic light-emitting display panel, but embodiments of the present disclosure are not limited thereto.

In the display panel DP, the base layer BL may be a member providing a base surface on which the display layer D-EL is disposed. The base layer BL may be rigid or flexible. The base layer BL may be a glass substrate, a metal substrate, a polymer substrate, or the like. However, embodiments of the present disclosure are not limited thereto, and the base layer BL may include an inorganic layer, an organic layer, or a composite material layer.

The base layer BL may have not only a single-layered structure but also a multi-layered structure. For example, the base layer BL may also have a three-layered structure of a polymer resin layer, an adhesive layer, and a polymer resin layer. Particularly, the polymer resin layer may include polyimide-based resin. In some aspects, the polymer resin layer may include at least one of an acrylate-based resin, a vinyl-based resin, an epoxy-based resin, a urethane-based resin, a cellulose-based resin, a siloxane-based resin, or a perylene-based resin. In this specification, a "~~based" resin is considered as including a functional group of "~~".

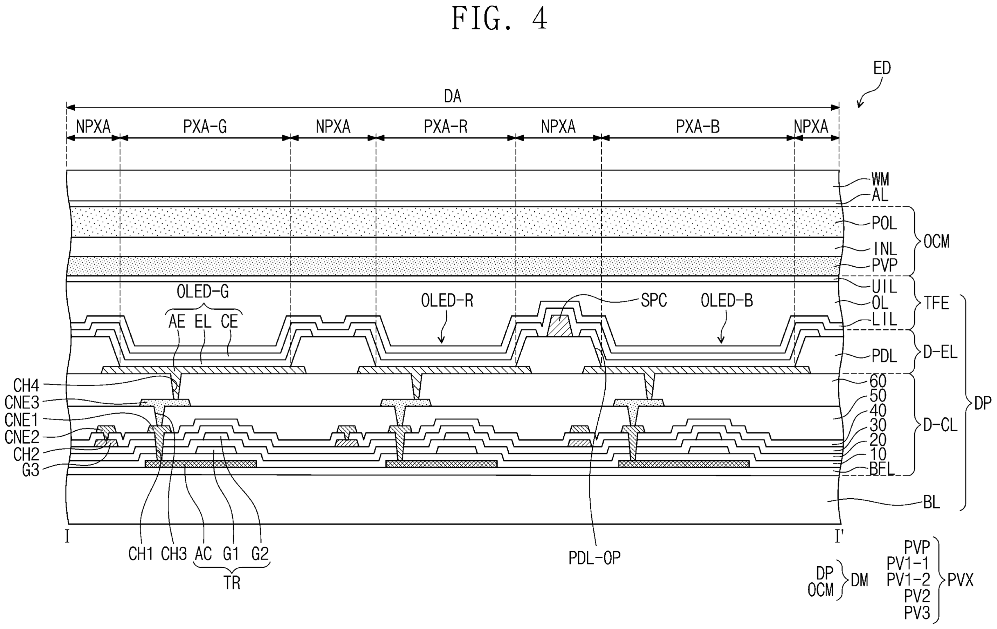

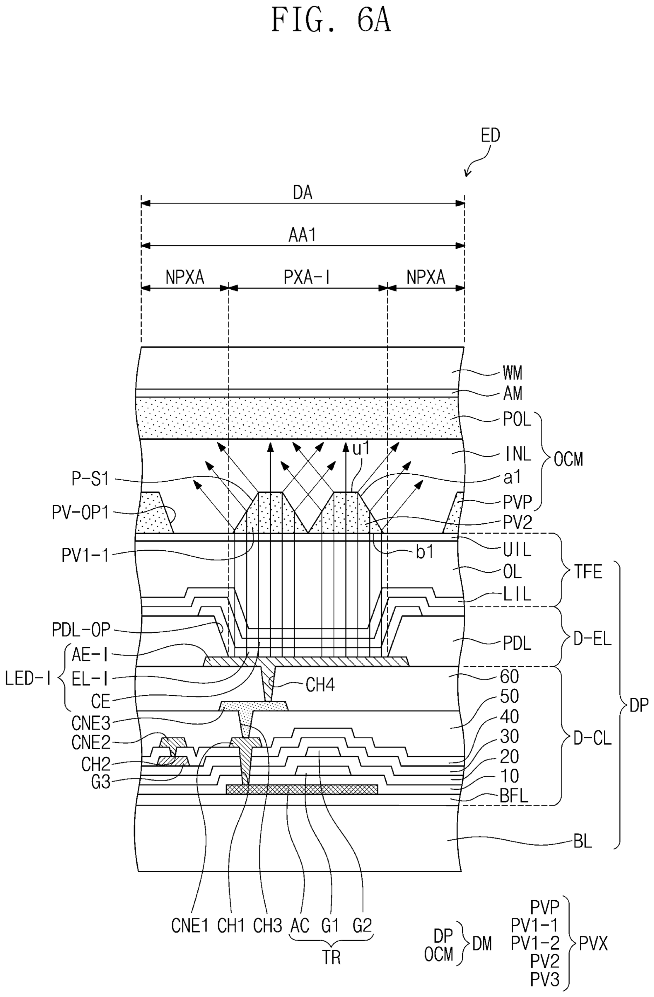

The circuit element layer D-CL may be disposed on the base layer BL. The circuit element layer D-CL may include an insulating layer, a semiconductor pattern, a conductive pattern, a signal line, and the like. The circuit element layer D-CL may include a plurality of transistors which include the semiconductor pattern, the conductive pattern, the signal line, and the like. The transistors may each include a control electrode, an input electrode, and an output electrode. For example, the circuit element layer D-CL may include a switching transistor and a driving transistor for driving first to third light-emitting elements OLED-R, OLED-G, and OLED-B (see FIG. 4), and an IR light-emitting element LED-I (see FIG. 6A).

The display layer D-EL may be disposed on the circuit element layer D-CL. The display layer D-EL may include the first to third light-emitting elements OLED-R, OLED-G, and OLED-B (FIG. 4), and the IR light-emitting element LED-I (FIG. 6A). The first to third light-emitting elements OLED-R, OLED-G, and OLED-B (FIG. 4) emit light having a visible wavelength band, and the IR light-emitting element LED-I (FIG. 6A) emits light having an infrared wavelength band. The light generated from the display layer D-EL may pass through the light control member OCM disposed above the display layer D-EL and be emitted to an upper surface of the electronic device ED.

The encapsulation layer TFE may be disposed on the display layer D-EL and cover the first to third light-emitting elements OLED-R, OLED-G, and OLED-B (see FIG. 4) and the IR light-emitting element LED-I (FIG. 6A).

The encapsulation layer TFE may be disposed on the display layer D-EL. The encapsulation layer TFE may protect the display layer D-EL against moisture, oxygen, and foreign substances such as dust particles. Accordingly, the encapsulation layer TFE may improve reliability of the electronic device ED.

The encapsulation layer TFE may be disposed on the display layer D-EL. The encapsulation layer TFE may function to prevent foreign substances such as moisture/oxygen from permeating into the display layer D-EL. The encapsulation layer TFE may have a structure in which organic and inorganic layers are alternately stacked.

The light control member OCM may be disposed above the display layer D-EL. The light control member OCM may control the extraction direction and the amount of light emitted from the display layer D-EL. Since the electronic device ED according to an embodiment may include the light control member OCM, light having an infrared wavelength band generated from the display layer D-EL may be emitted in a surface light source form. The detail thereof will be described later.

The display module DM may further include an input sensor. The input sensor may acquire coordinate information about an external input. The input sensor may sense an external input through a capacitive method, a magnetic induction method, or a pressure sensing method. The input sensor may be directly disposed on the encapsulation layer TFE.

The display surface IS of the electronic device ED may include a display region DA and a non-display region NDA. The non-display region NDA may be disposed in the outer periphery of at least one side of the display region DA. In an embodiment, the non-display region NDA may surround the display region DA. However, embodiments of the present disclosure are not limited thereto. In an embodiment of the inventive concept, the non-display region NDA may be omitted.

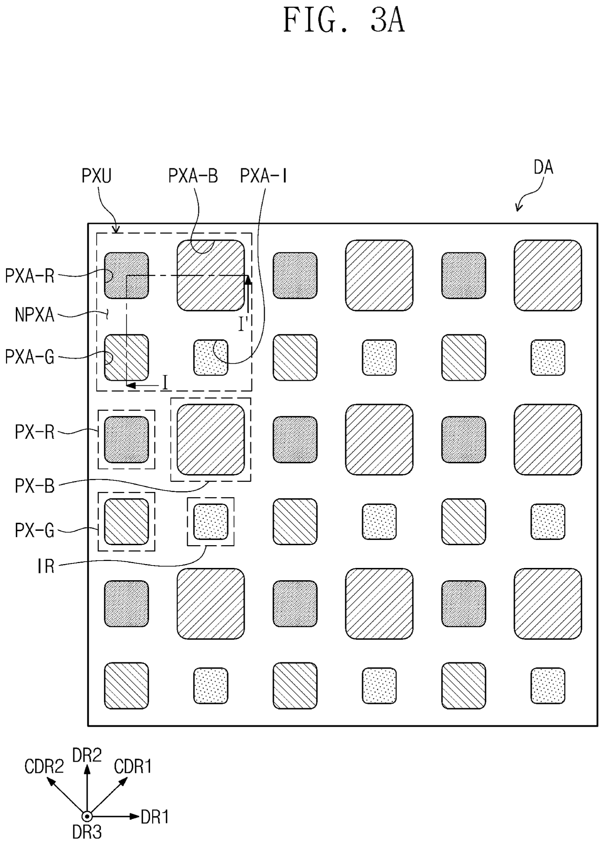

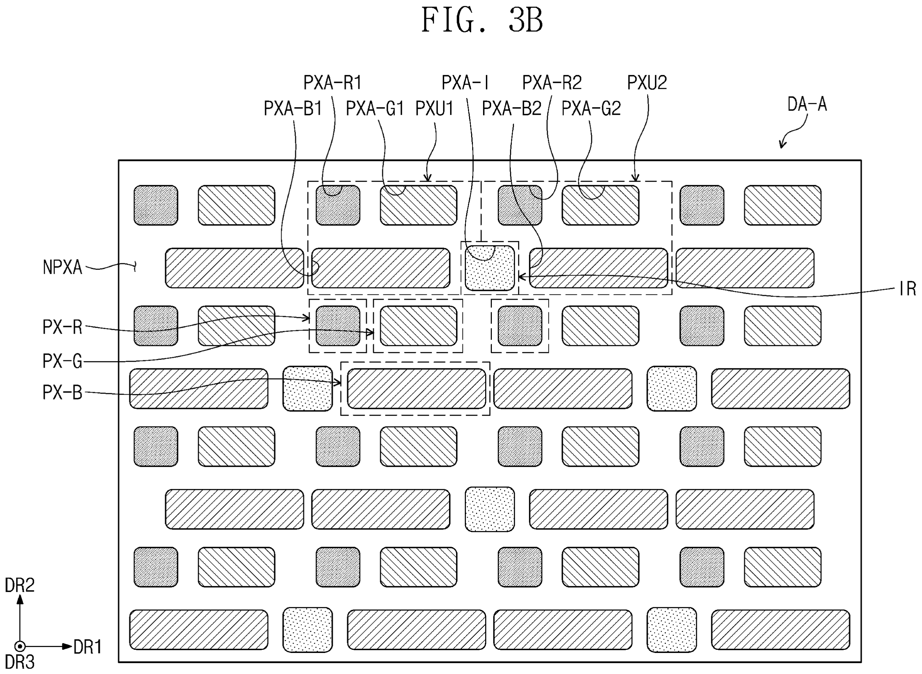

FIG. 3A is a plan view of a display surface according to an embodiment of the inventive concept. FIG. 3B is a plan view of a display surface according to an embodiment of the inventive concept. FIG. 4 is a cross-sectional view, of an electronic device, taken along line I-I' of FIG. 3A.

Referring to FIG. 3A, a unit pixel PXU may be disposed in a display region DA. The unit pixel PXU may be provided in plurality, and the unit pixels PXU may be arranged to be spaced apart from each other along the first direction DR1 and the second direction DR2.

One unit pixel PXU may include first to third pixels PX-G, PX-R, and PX-B which emit different visible light, and an IR emitter IR which emits light having an infrared wavelength band. Accordingly, in this embodiment, one IR emitter IR may be included in one unit pixel PXU. FIG. 3A illustrates, as a dotted line, a region in which a first electrode (an anode) included in the first to third pixels PX-G, PX-R, and PX-B is disposed.

The first to third pixels PX-G, PX-R, and PX-B may emit light having different visible wavelength bands. For example, the first pixel PX-G may emit light having a green wavelength band, the second pixel PX-R may emit light having a red wavelength band, and the third pixel PX-B may emit light having a blue wavelength band. The IR emitter IR may emit light having an infrared wavelength band.

A region in which light emitted from the first pixel PX-G is provided may be defined as a first light-emitting region PXA-G, a region in which light emitted from the second pixel PX-R is provided may be defined as a second light-emitting region PXA-R, and a region in which light emitted from the third pixel PX-B is provided may be defined as a third light-emitting region PXA-B. In some aspects, a region in which infrared light emitted from the IR emitter IR is provided may be defined as an IR light-emitting region PXA-I.

The first light-emitting region PXA-G and the IR light-emitting region PXA-I may be spaced apart from each other along the first direction DR1 and be disposed in the same first row. The second light-emitting region PXA-R and the third light-emitting region PXA-B may be spaced apart from each other along the first direction DR1 and be disposed in the same second row. The first and second rows may be spaced apart from each other along the second direction DR2.

The first light-emitting region PXA-G and the second light-emitting region PXA-R may be spaced apart from each other along the second direction DR2, and the third light-emitting region PXA-B and the IR light-emitting region PXA-I may be spaced apart from each other along the second direction DR2.

The first light-emitting region PXA-G and the third light-emitting region PXA-B may be spaced apart from each other in a first oblique direction CDR1 with respect to the first and second directions DR1 and DR2, and the IR light-emitting region PXA-I and the second light-emitting region PXA-R may be spaced apart from each other along a second oblique direction CDR2 crossing the first oblique direction.

According to this embodiment, the first to third light-emitting regions PXA-G, PXA-R, and PXA-B may have a quadrilateral shape with rounded corners. The first to third light-emitting regions PXA-G, PXA-R, and PXA-B may have different areas. For example, the area of the first light-emitting region PXA-G may be greater than the area of the second light-emitting region PXA-R, and the area of the first light-emitting region PXA-G may be smaller than the area of the third light-emitting region PXA-B. The area of the IR light-emitting region PXA-I may be smaller than each of the areas of the first to third light-emitting regions PXA-G, PXA-R, and PXA-B.

According to the inventive concept, the amount and/or form of infrared light provided from the IR light-emitting region PXA-I may vary according to regions of the electronic device ED. For example, the IR light-emitting region PXA-I disposed at the center of the electronic device ED may be provided more in a surface light source form than the IR light-emitting region PXA-I disposed in the outer periphery. The details thereof will be described later.

Referring to FIG. 3B, a first unit pixel PXU1 and a second unit pixel PXU2 may be disposed in a display region DA-A. The first unit pixel PXU1 and the second unit pixel PXU2 may be provided in plurality, and the first unit pixel PXU1 and the second unit pixel PXU2 may be alternately arranged along the first direction DR1. One row may include the first unit pixels PXU1 and the second unit pixels PXU2 which are alternately arranged along the first direction DR1, and rows may be arranged to be spaced apart from each other along the second direction DR2.

The first and second unit pixels PXU1 and PXU2 may each include first to third pixels PX-G, PX-R, and PX-B which emit different visible light. According to this embodiment, one IR emitter IR may be disposed commonly in two first and second unit pixels PXU1 and PXU2.

A first light-emitting region PXA-G and a second light-emitting region PXA-R may be spaced apart from each other along the first direction DR1 and be disposed in the same row. A third light-emitting region PXA-B may extend along the first direction DR1 and overlap the first light-emitting region PXA-G and the second light-emitting region PXA-R when viewed in the second direction DR2. Accordingly, the third light-emitting region PXA-B may be disposed in a different row from the first light-emitting region PXA-G and the second light-emitting region PXA-R, and be spaced apart from the first light-emitting region PXA-G and the second light-emitting region PXA-R along the second direction DR2.

According to this embodiment, the first and third light-emitting regions PXA-G and PXA-B may extend along the first direction DR1 and have a rectangular shape with rounded corners. The second light-emitting region PXA-R may have a quadrangular shape with rounded corners.

According to this embodiment, the first to third light-emitting regions PXA-G, PXA-R, and PXA-B may have different areas. For example, the area of the first light-emitting region PXA-G may be greater than the area of the second light-emitting region PXA-R, and the area of the first light-emitting region PXA-G may be smaller than the area of the third light-emitting region PXA-B. The area of an IR light-emitting region PXA-I may be smaller than each of the areas of the first to third light-emitting regions PXA-G, PXA-R, and PXA-B.

According to the inventive concept, the amount and/or form of infrared light provided from the IR light-emitting region PXA-I may vary according to regions of the electronic device ED. For example, the IR light-emitting region PXA-I disposed at the center of the electronic device ED may be provided more in a surface light source form than the IR light-emitting region PXA-I disposed in the outer periphery. The details thereof will be described later.

FIG. 4 illustrates a cross-sectional view of an electronic device ED corresponding to first to third pixels PX-G, PX-R, and PX-B.

Referring to FIG. 4, the electronic device ED may include a display module DM and a window module WM. An adhesive layer AM may bond the window module WM and a light control member OCM. The adhesive layer AM according to an embodiment may be an optically clear adhesive layer (OCA). In an embodiment, the window module WM may also be omitted.

A display panel DP may include a base layer BL, a circuit element layer D-CL, a display layer D-EL, and an encapsulation layer TFE. The display panel DP may be a component for substantially generating an image.

The circuit element layer D-CL, the display layer D-EL, and the encapsulation layer TFE are sequentially disposed on the base layer BL.

The circuit element layer D-CL includes at least one insulating layer and a circuit element. The circuit element includes a signal line, a pixel driving circuit, and the like. The circuit element layer D-CL may be formed through a process of forming an insulating layer, a semiconductor layer, and a conductive layer by performing coating, deposition, or the like, and a process of patterning the insulating layer, the semiconductor layer, and the conductive layer through photolithography.

A buffer layer BFL may be disposed on the base layer BL. The buffer layer BFL may include a plurality of stacked inorganic layers. A semiconductor pattern AC is disposed on the buffer layer BFL. The buffer layer BFL improves a bonding force between the base layer BL and the semiconductor pattern AC.

The semiconductor pattern AC may include polysilicon. However, embodiments of the present disclosure are not limited thereto, and the semiconductor pattern AC may also include amorphous silicon or a metal oxide. FIG. 4 illustrates a portion of the semiconductor pattern AC, and the semiconductor pattern AC may be further disposed in other regions of first to third pixels PX-G, PX-R, and PX-B on a plane. The semiconductor pattern AC may be arranged in a specific order throughout the first to third pixels PX-G, PX-R, and PX-B.

The first to third pixels PX-G, PX-R, and PX-B may include a transistor TR and light-emitting elements OLED-G, OLED-R, and OLED-B connected to the transistor TR, respectively. Hereinafter, the transistor TR and the light-emitting element OLED-G included in the first pixel PX-G will be described, and the description may be applied to the second and third pixels PX-R and PX-B in common.

The electrical properties of the semiconductor pattern AC vary depending on whether doped or not. The semiconductor pattern AC may include a first region (an active) having low doping concentration and conductivity, and second regions having relatively higher doping concentration and conductivity. The second regions substantially serve as an electrode or a signal line. One second region may correspond to a source of a transistor, and another second region may correspond to a drain.

One second region (a source) may be disposed on one side of the first region (the active), and another second region (the drain) may be disposed on the other side of the first region (the active). The second regions may be doped with an N-type dopant or a P-type dopant. A P-type transistor includes a doped region which is doped with the P-type dopant. The first region may be a non-doped region or be doped at a lower concentration than the second region.

A first insulating layer 10 is disposed on the buffer layer BFL. The first insulating layer 10 overlaps the first to third pixels PX-G, PX-R, and PX-B in common, and covers each of the semiconductor patterns AC. The first insulating layer 10 may be an inorganic layer and/or an organic layer and have a single- or multi-layered structure. The first insulating layer 10 may include at least one among an aluminum oxide, a titanium oxide, a silicon oxide, a silicon oxynitride, a zirconium oxide, and a hafnium oxide. An insulating layer of the circuit element layer D-CL, which will be described later, as well as the first insulating layer 10 may be an inorganic layer and/or an organic layer, and may have a single- or multi-layered structure.

A lower gate G1 is disposed on the first insulating layer 10. The lower gate G1 may include a multi-layered metal layer. The lower gate G1 overlaps the first region. During a process of doping the semiconductor pattern AC, the lower gate G1 serves as a mask.

A second insulating layer 20 covering the lower gate G1 is disposed on the first insulating layer 10. The second insulating layer 20 overlaps the first to third pixels PX-G, PX-R, and PX-B in common. An upper gate G2 may be disposed on the second insulating layer 20. The upper gate G2 may overlap the lower gate G1. The upper gate G2 may include a multi-layered metal layer. In an embodiment of the inventive concept, the upper gate G2 may also be omitted.

A third insulating layer 30 covering the upper gate G2 is disposed on the second insulating layer 20. An additional gate G3 may be disposed on the third insulating layer 30. The additional gate G3 may be a component overlapping semiconductor pattern which is included in another transistor.

A fourth insulating layer 40 is disposed on the third insulating layer 30. A first connection electrode CNE1 and a second connection electrode CNE2 may be disposed on the fourth insulating layer 40. The first connection electrode CNE1 may be connected to the semiconductor pattern AC via a first contact hole CH1 which passes through the first to fourth insulating layers 10, 20, 30, and 40. The second connection electrode CNE2 may be connected to the additional gate G3 via a second contact hole CH2 which passes through the fourth insulating layer 40.

A fifth insulating layer 50, covering the first connection electrode CNE1 and the second connection electrode CNE2, is disposed on the fourth insulating layer 40. The fifth insulating layer 50 may be an organic layer. A third connection electrode CNE3 may be disposed on the fifth insulating layer 50. The third connection electrode CNE3 may be connected to the first connection electrode CNE1 via a third contact hole CH3 which passes through the fifth insulating layer 50.

A sixth insulating layer 60, covering the third connection electrode CNE3, is disposed on the fifth insulating layer 50. The sixth insulating layer 60 may be an organic layer. The light-emitting elements OLED-G, OLED-R, and OLED-B may be disposed on the sixth insulating layer 60.

A first electrode AE (or an anode) is disposed on the sixth insulating layer 60. The first electrode AE is connected to the third connection electrode CNE3 via a fourth contact hole CH4 which passes through the sixth insulating layer 60.

A pixel-defining film PDL is disposed on the sixth insulating layer 60. A display opening PDL-OP is defined in the pixel-defining film PDL. The display opening PDL-OP of the pixel-defining film PDL exposes at least a portion of the first electrode AE. The pixel-defining film PDL may be an organic layer.

According to an embodiment, a spacer SPC, disposed on the pixel-defining film PDL, may be further included. The spacer SPC may be a component which supports a mask during a deposition process.

As illustrated in FIG. 4, the display region DA may include first to third light-emitting regions PXA-G, PXA-R, and PXA-B, and a non-light-emitting region NPXA disposed between the first to third light-emitting regions PXA-G, PXA-R, and PXA-B. The non-light-emitting region NPXA may surround the light-emitting region PXA. In this embodiment, the first to third light-emitting regions PXA-G, PXA-R, and PXA-B are defined to correspond to a region, of the first electrode AE, which is exposed by the display opening PDL-OP. The first to third light-emitting regions PXA-G, PXA-R, and PXA-B may have different areas as illustrated in FIG. 3A.

A light-emitting layer EL is disposed on the first electrode AE. The light-emitting layer EL may be disposed in a region corresponding to the display opening PDL-OP. That is, the light-emitting layer EL may be provided separately in each of the first to third pixels PX-G, PX-R, and PX-B.

A second electrode CE may be disposed on the light-emitting layer EL. The second electrode CE has an integral shape, and is disposed in the first to third pixels PX-G, PX-R, and PX-B in common. An encapsulation layer TFE is disposed on the second electrode CE.

According to an embodiment, a hole control layer, disposed between the first electrode AE and the light-emitting layer EL, may be further included. The hole control layer may be disposed in the first to third pixels PX-G, PX-R, and PX-B in common. The hole control layer may further include at least one of a hole transport layer or a hole injection layer.

In some aspects, an electron control layer, disposed between the light-emitting layer EL and the second electrode CE, may be further included. The electron control layer may further include at least one of an electron transport layer or an electron injection layer. The hole control layer and the electron control layer may be provided in the first to third pixels PX-G, PX-R, and PX-B in common by using an open mask.

The encapsulation layer TFE may include a first inorganic layer LIL, an organic layer OL, and a second inorganic layer UIL. The first inorganic layer LIL and the second inorganic layer UIL may include an inorganic material, and the organic layer OL may include an organic material. The first inorganic layer LIL and the second inorganic layer UIL protect a display layer D-EL against moisture/oxygen, and the organic layer OL protects the display layer D-EL against foreign substances such as dust particles.

According to an embodiment, a capping layer, disposed between the second electrode CE and the first inorganic layer LIL, may be further included. The capping layer may include an organic material.

The light control member OCM may be disposed on the encapsulation layer TFE. The light control member OCM may include a first optical layer PVX, a second optical layer INL, a third optical layer POL which are disposed on the second inorganic layer UIL.

The first optical layer PVX may be disposed on the second inorganic layer UIL. The first optical layer PVX may include an organic material different from an organic material of the second optical layer INL. The first optical layer PVX may have a refractive index of about 1.45 to about 1.55.

In the first optical layer PVX, different components may be disposed in respective regions of the display surface IS of the electronic device ED. The first optical layer PVX may include a passivation layer PVP, first patterns PV1-1 and PV1-2, a second pattern PV2, a third pattern PV3. The passivation layer PVP, the first patterns PV1-1 and PV1-2, the second pattern PV2, and the third pattern PV3 may be components which are patterned by one organic layer formed through the same process. Accordingly, the thicknesses along the third direction DR3 may be equal to each other, and the same material may be included.

The passivation layer PVP may be disposed throughout a display region DA. As illustrated in FIG. 4, in the display region DA, the passivation layer PVP may be disposed in a region in which the first to third pixels PX-G, PX-R, and PX-B are disposed.

The second optical layer INL may be disposed on the first optical layer PVX. The second optical layer INL may include an organic material different from an organic material of the first optical layer PVX. The second optical layer INL may be provided on the first optical layer PVX through an inkjet process. The second optical layer INL may have a refractive index different from a refractive index of the first optical layer PVX. The second optical layer INL may have a refractive index of about 1.60 to about 1.70.

The third optical layer POL may be disposed on the second optical layer INL. The third optical layer POL may include a polarization plate or a color filter layer. For example, the third optical layer POL may include at least one of a retarder, a polarizer, a polarization film, or a polarization filter. Alternatively, the third optical layer POL may include a plurality of color filters which are disposed in a predetermined arrangement, and a black matrix adjacent to the color filters.

The window module WM may be disposed on the light control member OCM. The adhesive layer AM may bond the window module WM and the light control member OCM. The adhesive layer AM may be an optically clear adhesive layer (OCA). In an embodiment, the window module WM may also be omitted.

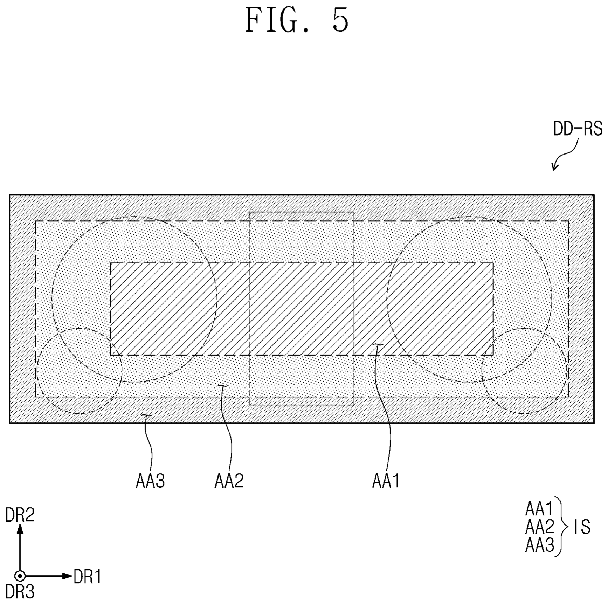

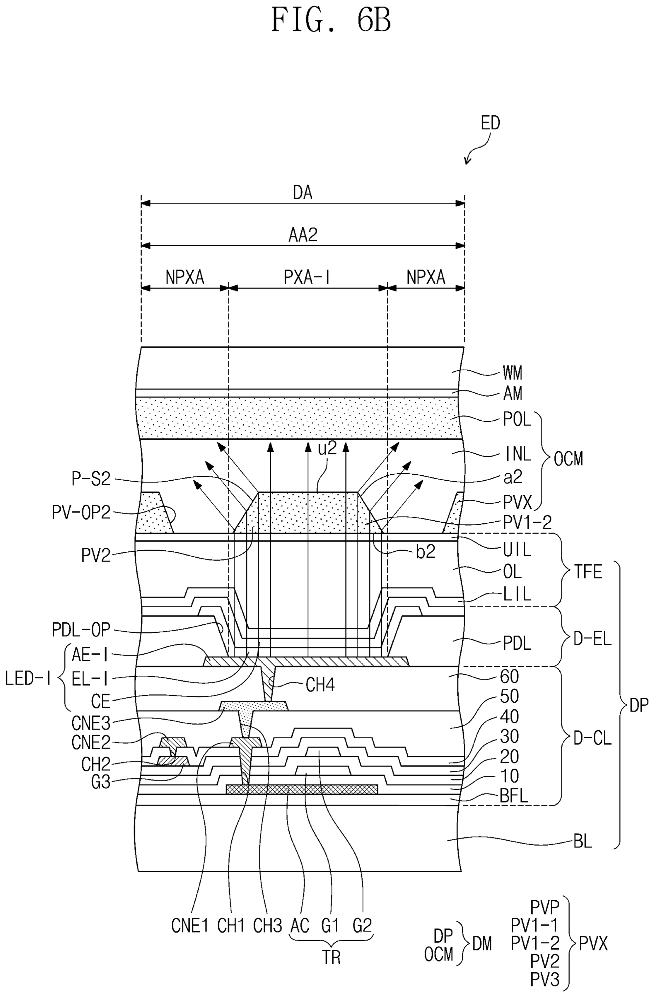

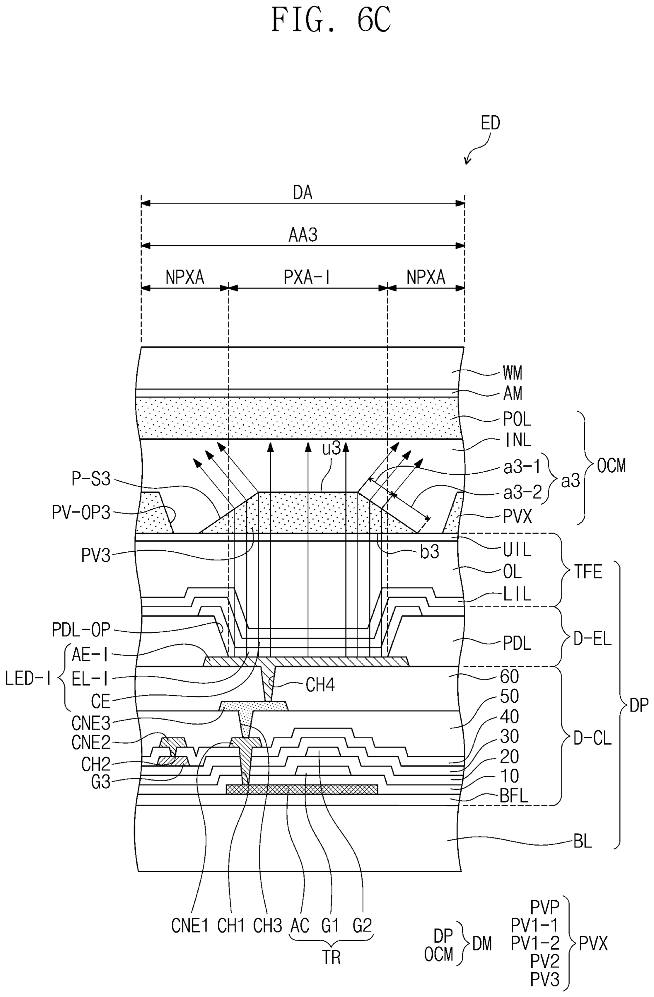

FIG. 5 is a plan view of an electronic device included in a vehicle according to an embodiment of the inventive concept. FIG. 6A is a cross-sectional view of a first region of a cluster according to an embodiment of the inventive concept. FIG. 6B is a cross-sectional view of a second region of a cluster according to an embodiment of the inventive concept. FIG. 6C is a cross-sectional view of a third region of a cluster according to an embodiment of the inventive concept.

FIG. 5 is a plan view illustrating the display surface IS of the first electronic device DD-RS among the electronic devices DD-RS, DD-CT, and DD-PS described in FIG. 1C. The description of the display surface IS of the first electronic device DD-RS may be applied to other electronic devices DD-CT and DD-PS in common. FIG. 5 illustrates example components about a vehicle, such as a dashboard, as the dotted circles and squares.

Referring to FIG. 5, the display surface IS may include a first region AA1, a second region AA2, and a third region AA3. Expressed another way, the base layer BL may include a first region AA1, a second region AA2, and a third region AA3. The first region AA1 may be disposed at the center, the second region AA2 may surround the second region AA2, and the third region AA3 may surround the second region AA2 with respect to a vehicle's driver. The unit pixels PXU described in FIG. 3A or the first and second unit pixels PXU1 and PXU2 described in FIG. 3B may be disposed in the first region AA1, the second region AA2, and the third region AA3.

According to the inventive concept, infrared light emitted from an IR emitter IR may be provided such that the infrared light is more similar to a surface light source form in a direction from the third region AA3 to the first region AA1, and from the second region AA2 toward the first region AA1. This may be implemented by disposing different patterns in the respective first to third regions AA1, AA2, and AA3 of the first optical layer PVX.

Descriptions herein of providing light (e.g., infrared light) such that the light is more similar to a surface light source form may refer to providing the light using an indirect lighting approach, in which the emitted light is first reflected off of or refracted by another surface before reaching the intended target (e.g., a driver). In contrast, direct lighting may refer to emitting light straight from a light source onto an intended target. The term "surface light source form" may therefore be seen as referring to the visible effect of light that has been, e.g., reflected or diffused by a surface or structure, where the light source itself is concealed or not directly visible. This typically results in a soft and diffuse illumination created by an entire surface area or structure acting as a secondary, large-area light source, rather than illumination created by a single point-like light source.

In an example of providing infrared light emitted from an IR emitter IR such that the infrared light more similar to a surface light source form in a direction from the third region AA3 to the first region AA1, the infrared light may more indirectly light a target in the direction from the third region AA3 to the first region AA. Expressed another way, the infrared light emitted from the first region AA1 may be more indirect in lighting a target compared to the infrared light emitted from the second region AA2 (e.g., due to respective patterns, transmittances, and/or refractive indexes at the first region AA1 and the second region AA2), and the infrared light emitted from the second region AA2 may be more indirect in lighting the target compared to the infrared light emitted from the third region AA3 (e.g., due to respective patterns, transmittances, and/or refractive indexes at the second region AA2 and the third region AA3). Expressed another way, infrared light emitted from the third region AA3 may more directly light a target compared to infrared light emitted from the second region AA2 , and the infrared light emitted from the second region AA2 may more directly light the target compared to infrared light emitted from the first region AA1.

According to the inventive concept, infrared light, provided from the first region AA1 which is disposed at the center of the display surface IS, is provided to driver's pupils and facial muscles in a surface light source form, and thus a driver's condition may be easily analyzed via an infrared camera IR-C. Specifically, according to the inventive concept, when a driver wears glasses, infrared light is provided in a surface light source form, and thus reflectivity may be reduced compared to when infrared light is provided to the glasses in a direct light form. This makes it possible to easily track a gaze of a driver wearing glasses and monitor more accurately driver's status in real-time during autonomous driving, thereby preventing drowsy driving.

In some aspects, since the IR emitter IR is disposed inside a display panel DP, a separate IR emitter for monitoring a driver may be omitted. Accordingly, an increased vehicle's interior space, enhanced design flexibility, and improved vehicle interior aesthetic may be achieved.

Referring to FIGS. 6A to 6C, the relationship between patterns of a first optical layer PVX disposed by regions and infrared light emitted from an IR emitter IR will be described.

Referring to FIGS. 6A to 6C, an electronic device ED may include a structure same as the stacking structure described in FIG. 4. The duplicated description thereof will be omitted.

The IR emitter IR may include a light-emitting element LED-I connected to a transistor TR which is included in a circuit element layer D-CL. The light-emitting element LED-I may include a first electrode AE-I, a second electrode CE, and a light-emitting layer EL-I. The second electrode CE may be provided as a common layer.

The first electrode AE-I is disposed on a sixth insulating layer 60. The first electrode AE-I is connected to a third connection electrode CNE3 via a fourth contact hole CH4 which passes through the sixth insulating layer 60.

A pixel-defining film PDL is disposed on the sixth insulating layer 60. A display opening PDL-OP is defined in the pixel-defining film PDL. The display opening PDL-OP of the pixel-defining film PDL exposes at least a portion of the first electrode AE-I.

A light-emitting layer EL-I is disposed on the first electrode AE-I. The light-emitting layer EL-I may be disposed in a region corresponding to the display opening PDL-OP. The light-emitting layer EL-I may include an organic material having an emission spectrum of around 800 nm or more, but is not limited thereto.

The light-emitting layer EL-I may include a resonance auxiliary material, and an infrared ray light-emitting dopant which is doped to the resonance auxiliary material. For example, the infrared ray light-emitting dopant may include at least one among a metal complex compound, a donor-acceptor-donor (DAD) compound, and a lanthanide compound, but is not limited thereto. The metal complex compound may include at least one among Pt, Pd, Cu, and Zn. A switching transistor applies a driving voltage to the first electrode AE-I of the IR emitter IR, and if the second electrode CE receives a common voltage or a low potential voltage, holes and electrons may move to the light-emitting layer EL-I through a hole transport layer and an electron transport layer, and combine in light-emitting layer EL-I to emit infrared light. The second electrode CE may transmit infrared light.

FIG. 6A illustrates a cross-sectional view of the IR emitter IR overlapping the first region AA1, FIG. 6B illustrates a cross-sectional view of the IR emitter IR overlapping the second region AA2, and FIG. 6C illustrates a cross-sectional view of the IR emitter IR overlapping the third region AA3.

The first optical layer PVX may include a passivation layer PVP, first patterns PV1-1 and PV1-2, a second pattern PV2, a third pattern PV3.

First to third openings PV-OP1, PV-OP2, and PV-OP3 may be defined in the passivation layer PVP. The first opening PV-OP1 may overlap the IR emitter IR disposed in the first region AA1. The second opening PV-OP2 may overlap the IR emitter IR disposed in the second region AA2. The third opening PV-OP3 may overlap the IR emitter IR disposed in the third region AA3.

Referring to FIG. 6A, the first patterns PV1-1 and PV1-2 may be disposed on the encapsulation layer TFE overlapping the first opening PV-OP1. The first patterns PV1-1 and PV1-2 may be disposed adjacent to each other. A portion of the second optical layer INL may be disposed in the first opening PV-OP1 and be in contact with the encapsulation layer TFE which is exposed from the first patterns PV1-1 and PV1-2.

On a cross section, the first patterns PV1-1 and PV1-2 may each have a trapezoidal shape. The first patterns PV1-1 and PV1-2 may each include a first upper surface u1, a first lower surface b1, and inclined first side surfaces a1.

According to this embodiment, in the first region AA1, the width of the first electrode AE-I which is exposed by the display opening PDL-OP of the pixel-defining film PDL may be equal to the sum of the widths of the first lower surfaces b1. Therefore, infrared light emitted from the IR emitter IR which is disposed in the first region AA1 may pass through the first lower surfaces b1 of the first patterns PV1-1 and PV1-2 to be provided to the first side surfaces a1, and may pass through the second optical layer INL, which has a higher refractive index than the first optical layer PVX, to be provided to a driver.

The longer the lengths of the side surfaces included in the pattern are, that is, the greater the areas of the side surfaces are, the more infrared light may be scattered to be provided in a surface light source form. According to this embodiment, on a cross section, in the first patterns PV1-1 and PV1-2, a first length of each of the first side surfaces a1 through which infrared light passes may be defined as 4*a1.

Referring to FIG. 6B, a second pattern PV2 may be disposed on an encapsulation layer TFE overlapping a second opening PV-OP2. A portion of the second optical layer INL may be disposed in the second opening PV-OP2 and be in contact with the encapsulation layer TFE which is exposed from the second pattern PV2.

On a cross section, the second pattern PV2 may have a trapezoidal shape. The second pattern PV2 may include a second upper surface u2, a second lower surface b2, and inclined second side surfaces a2.

According to this embodiment, in the second region AA2, the width of the first electrode AE-I which is exposed by the display opening PDL-OP of the pixel-defining film PDL may be equal to the width of the second lower surface b2. Therefore, infrared light emitted from the IR emitter IR which is disposed in the second region AA2 may pass through the second lower surface b2 of the second pattern PV2 to be provided to the second side surfaces a2, and may pass through the second optical layer INL which has a higher refractive index than the first optical layer PVX to be provided to a driver.

According to this embodiment, on a cross section, in the second pattern PV2, a second length of each of the second side surfaces a2 through which infrared light passes may be defined as 2*a2. The second length denoted by 2*a2, may be smaller than the first length denoted by 4*a1.

Referring to FIG. 6C, the third pattern PV3 may be disposed on an encapsulation layer TFE overlapping a third opening PV-OP3. A portion of the second optical layer INL may be disposed in the third opening PV-OP3 and be in contact with the encapsulation layer TFE which is exposed from the third pattern PV3.

On a cross section, the third pattern PV3 may have a trapezoidal shape. The third pattern PV3 may include a third upper surface u3, a third lower surface b3, and inclined third side surfaces a3.

According to this embodiment, in the third region AA3, the width of the first electrode AE-I exposed by the display opening PDL-OP of the pixel-defining film PDL may be smaller than the width of the third lower surface b3.

Accordingly, the third side surfaces a3 may each include a first portion a3-1 to which infrared light is provided, and a second portion a3-2 to which infrared light is not provided. Therefore, infrared light emitted from the IR emitter IR which is disposed in the second region AA2 may pass through the third lower surface b3 of the third pattern PV3 to be provided to the first portions a3-1, and may pass through the second optical layer INL, which has a higher refractive index than the first optical layer PVX, to be provided to a driver.

According to this embodiment, on a cross section, in the third pattern PV3, a third length of each of the third side surfaces a3 through which infrared light passes may be defined as 2*(a3-1 - a3-2). The third length denoted by 2*(a3-1 - a3-2) may be smaller than the second length, which is denoted by 2*a2, and smaller than the first length denoted by 4*a1. Accordingly, the amount of infrared light, which is emitted from the IR emitters IR and passes through the side surfaces, may increase in the order of the third pattern PV3, the second pattern PV2, and the first patterns PV1-1 and PV1-2.

According to the inventive concept, infrared light emitted from the IR emitters IR may be provided in different forms by regions. That is, the amount of infrared light, which passes through the inclined side surfaces of the patterns, increases as propagating from the third region AA3 toward the first region AA1, and thus infrared light may be transmitted to a driver in a surface light source form as propagating from the third region AA3 toward the first region AA1. Accordingly, when a driver wears glasses, the reflectivity may be reduced compared to when infrared light is provided to the glasses in a direct light form.

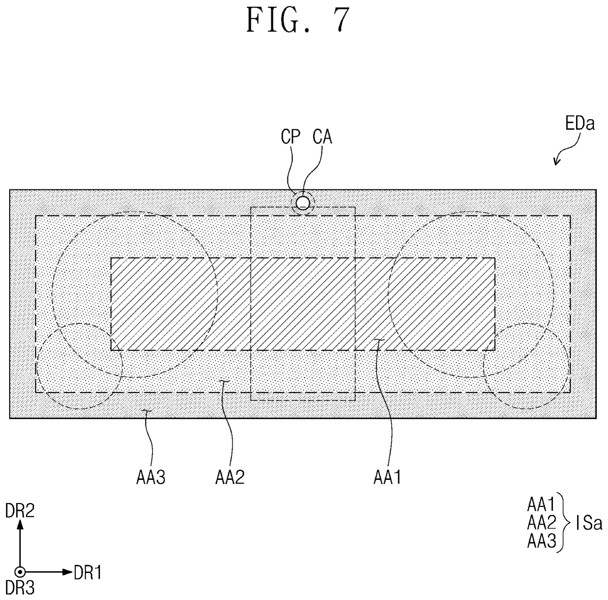

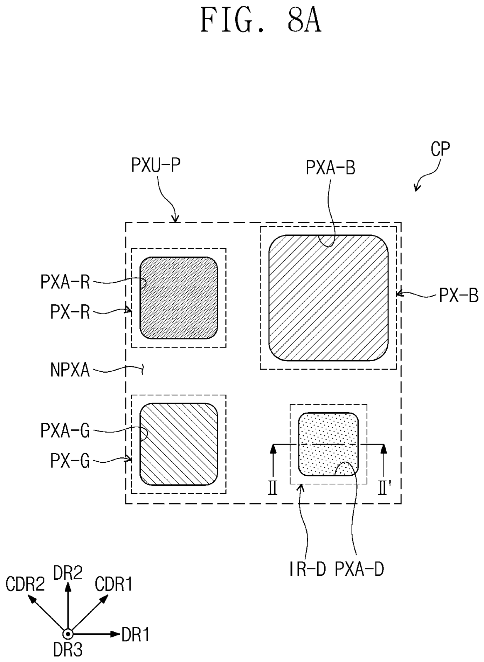

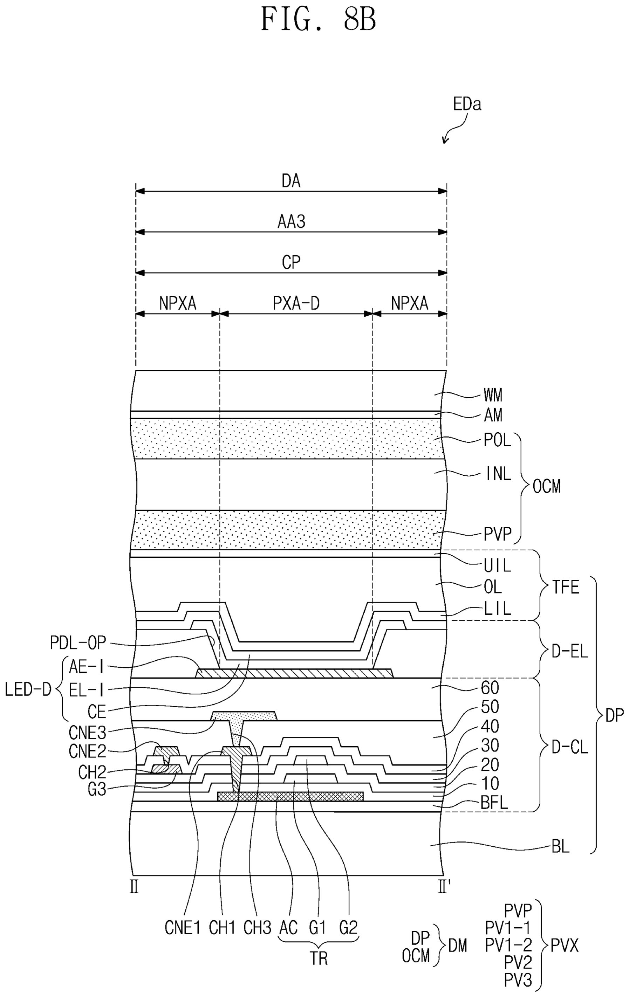

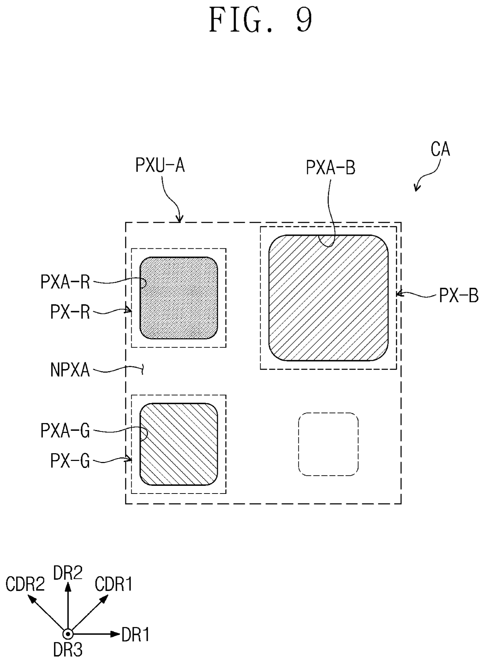

FIG. 7 is a plan view of an electronic device included in a vehicle according to an embodiment of the inventive concept. FIG. 8A is a plan view of a region between pixels in a display surface according to an embodiment of the inventive concept. FIG. 8B is a cross-sectional view of a region between pixels according to an embodiment of the inventive concept. FIG. 9 is a plan view of a transmission region in a display surface according to an embodiment of the inventive concept. The same/similar reference numerals or symbols are used for the components same as/similar to those described in FIGS. 3A to 6C, and a duplicated description thereof will be omitted.

FIG. 7 is a plan view of a display surface ISa of an electronic device EDa according to an embodiment. The description of the display surface ISa of the electronic device EDa to be described in FIG. 7 may be applied also to the electronic devices DD-RS, DD-CT, and DD-PS described in FIG. 1C in common. FIG. 7 illustrates example components about a vehicle, such as a dashboard, as the dotted circles and squares.

Referring to FIG. 7, the display surface ISa may include a first region AA1, a second region AA2, and a third region AA3. The first region AA1 may be disposed at the center, the second region AA2 may surround the second region AA2, and the third region AA3 may surround the second region AA2 with respect to a vehicle's driver.

According to this embodiment, the electronic device EDa may further include a dummy region CP and a transmission region CA. The third region AA3 may surround the dummy region CP, and the dummy region CP may surround the transmission region CA. However, embodiments of the present disclosure are not limited thereto, and the dummy region CP may be disposed inside any one of the first and second regions AA1 and AA2, or may overlap a boundary of the regions, and the dummy region CP is not limited to any one embodiment.

The infrared camera IR-C described in FIG. 1C may be disposed below the transmission region CA. Accordingly, a separate space in which the infrared camera IR-C is disposed may be omitted. The IR emitter IR and the infrared camera IR-C are disposed adjacent to each other, and thus a driver's status may be detected more accurately.

According to this embodiment, since the infrared camera IR-C is disposed below the electronic device EDa, the dummy region CP may be defined as a region to which infrared light is not provided, and the transmission region CA may be defined as a region in which light transmittance is relatively higher than the light transmittance of adjacent regions.

The display surface ISa may include the unit pixels PXU described in FIG. 3A which are disposed in the first region AA1, the second region AA2, and the third region AA3, and a structure on the cross section may be the same as that described in FIGS. 4, and 6A to 6C.

Referring to FIGS. 8A and 8B, a dummy unit pixel PXU-P may be disposed in a dummy region CP. The dummy unit pixel PXU-P is provided in plurality, and the arrangement form of the dummy unit pixels PXU-P may be the same as the arrangement form of the unit pixels PXU described in FIG. 3A.

One dummy unit pixel PXU-P may include first to third pixels PX-G, PX-R, and PX-B which emit different visible light and a dummy IR emitter IR-D. FIG. 8A illustrates, as a dotted line, a region in which a first electrode (an anode) included in the first to third pixels PX-G, PX-R, and PX-B is disposed. The description of the first to third pixels PX-G, PX-R, and PX-B may be the same as that of the first to third pixels PX-G, PX-R, and PX-B in FIG. 3A.

The dummy IR emitter IR-D may have a structure corresponding to a structure of the IR emitter IR described in FIG. 6A. However, a first electrode AE-I of the dummy IR emitter IR-D may be in a state of not being connected to a transistor TR. Accordingly, the dummy IR emitter IR-D disposed in the dummy region CP may not provide infrared light. In some aspects, since the dummy IR emitter IR-D includes the same components as the IR emitter IR, the dummy region CP may be invisible from the outside.

Referring to FIG. 9, a transmission unit pixel PXU-A may be disposed in a transmission region CA. The transmission unit pixel PXU-A is provided in plurality, and the arrangement form of the transmission unit pixels PXU-A may be the same as the arrangement form of the unit pixels PXU described in FIG. 3A.

The transmission unit pixel PXU-A may include first to third pixels PX-G, PX-R, and PX-B, which emit different visible light, without including other components. FIG. 9 illustrates, as a dotted line, a region in which a first electrode (an anode) included in the first to third pixels PX-G, PX-R, and PX-B is disposed. The description of the first to third pixels PX-G, PX-R, and PX-B may be the same as that of the first to third pixels PX-G, PX-R, and PX-B in FIG. 3A.

According to this embodiment, in the transmission unit pixel PXU-A, the IR emitter IR which emits infrared light may be omitted. Accordingly, the transmission region CA may have higher transmittance than adjacent regions. Therefore, even when the infrared camera IR-C is disposed below the electronic device EDa, the performance of the infrared camera IR-C may not be deteriorated.

According to an embodiment of the inventive concept, when drivers wear glasses, infrared light is provided in a surface light source form, and thus reflectivity may be reduced compared to when infrared light is provided to the glasses in a direct light form. This makes it possible to more accurately monitor driver's status in real-time during autonomous driving, thereby preventing drowsy driving.

In some aspects, since an IR emitter is disposed inside a display panel, a separate IR emitter for monitoring a driver may be omitted. Accordingly, an increased vehicle's interior space, enhanced design flexibility, and improved vehicle interior aesthetic may be achieved.

In the above, description has been made with reference to embodiments of the inventive concept, but those skilled or of ordinary skill in the art may understand that various modifications and changes may be made to the inventive concept insofar as such modifications and changes do not depart from the technical scope of the inventive concept set forth in the appended claims.

Therefore, the technical scope of the inventive concept is not to be limited to the contents stated in the detailed description of the specification, but determined by the appended claims.

## Claims

1. An electronic device (ED) comprising:
a processor (12) which provides image data and a display brightness value;
a display panel (DP) comprising unit pixels (PXU), wherein each of the unit pixels (PXU) comprises:
pixels (PX) which emit light having a visible wavelength band; and
an infrared, IR, emitter (IR) which emits light having an infrared wavelength band; and
a panel driver which receives the image data and the display brightness value and drives the display panel (DP) based on the image data and the display brightness value,
wherein:
the display panel (DP) further comprises:
a base layer (BL) comprising a first region (AA1), a second region (AA2) which surrounds the first region (AA1), and a third region (AA3) which surrounds the second region (AA2),
a circuit element layer (D-CL) comprising transistors (TR) which are comprised in the pixels (PX) and the IR emitter (IR),
a display layer (D-EL) comprising light-emitting elements (LED, OLED) which are respectively comprised in the pixels (PX) and the IR emitter (IR) and are respectively connected to the transistors (TR) comprised in the pixels (PX) and the IR emitter (IR),
an encapsulation layer (TFE) disposed on the display layer (D-EL), and
a light control member (OCM) disposed on the encapsulation layer (TFE),
wherein infrared light emitted from the IR emitter (IR) is provided such that the infrared light is more similar to a surface light source form in a direction from the third region (AA3) to the first region (AA1).

2. The electronic device (ED) of claim 1, wherein the light control member (OCM) comprises:
a first optical layer (PVX) disposed on the encapsulation layer (TFE);
a second optical layer (INL) disposed on the first optical layer (PVX); and
a third optical layer (POL) disposed on the second optical layer (INL).

3. The electronic device (ED) of claim 2, wherein the first optical layer (PVX) comprises:
a passivation layer (PVP) in which openings (PV-OP) overlapping the IR emitters (IR) and exposing the encapsulation layer (TFE) are defined;
first patterns (PV-1) disposed in a first opening (PV-OP1) which is included among the openings (PV-OP) and overlaps the first region (AA1);
a second pattern (PV-2) disposed in a second opening (PV-OP2) which is included among the openings and (PV-OP) overlaps the second region (AA2); and
a third pattern (PV-3) disposed in a third opening (PV-OP3) which is included among the openings (PV-OP) and overlaps the third region (AA3).

4. The electronic device (ED) of claim 3, wherein:
the first patterns (PV1) comprise a (1-1)-th pattern (PV1-1) and a (1-2)-th pattern (PV1-2) which are disposed adjacent to each other, and
on a cross section, the (1-1)-th pattern (PV1-1) and the (1-2)-th pattern (PV1-2) each have a trapezoidal shape comprising a first upper surface (u1) , a first lower surface (b1) which is opposed to the first upper surface (u1), and inclined first side surfaces (a1) which connect the first upper surface (u1) and the first lower surface (b1).

5. The electronic device (ED) of claim 4, wherein on a cross section, the second pattern (PV2) has a trapezoidal shape comprising a second upper surface (u2), a second lower surface (b2) which is opposed to the second upper surface (u2), and inclined second side surfaces (a2) which connect the second upper surface (u2) and the second lower surface (b2).

6. The electronic device of claim 5, wherein on a cross section, the third pattern (PV3) has a trapezoidal shape comprising a third upper surface (u3), a third lower surface (b3) which is opposed to the third upper surface (u3), and inclined third side surfaces (a3) which connect the third upper surface (u3) and the third lower surface (b3).

7. The electronic device (ED) of claim 6, wherein among the infrared light emitted from the **IR** emitter (IR), an amount of light which passes through and is emitted from the side surfaces (a) increases in the order of the third pattern (PV_3), the second pattern (PV-2), and the first patterns (PV-1).

8. The electronic device (ED) of claim 6 or 7, wherein:
the light-emitting elements (LED, OLED) respectively comprised in the pixels (PX) and the IR emitter (IR) each comprise a first electrode (AE), a second electrode (CE) which is disposed on the first electrode (AE), and a light-emitting layer (EL) which is disposed between the first electrode (AE) and the second electrode (CE), and
the display layer (D-EL) comprises a pixel-defining film (PDL) in which display openings (PDL-OP) exposing at least a portion of the first electrodes (AE) are defined.

9. The electronic device (ED) of claim 8, wherein on a cross section, a width of the third lower surface (b3) is greater than a width by which the first electrode (AE-I) of the IR emitter (IR) disposed in the third region (AA3) is exposed from the display opening (PDL-OP).

10. The electronic device (ED) of claim 8 or 9, wherein the third side surfaces (a3) each comprise:
a first portion (a3-1) through which the infrared light passes, and
a second portion (a3-2) through which the infrared light does not pass.

11. The electronic device (ED) of any one of claims 8 to 10,
wherein on a cross section, a sum of widths of the first lower surfaces (b1) is equal to a width by which the first electrode (AE-I) of the IR emitter (IR) disposed in the first region (AA1) is exposed from the display opening (PDL-OP); and/or
wherein on a cross section, a width of the second lower surface (b2) is equal to a width by which the first electrode (AE-I) of the IR emitter (IR) disposed in the second region (AA2) is exposed from the display opening (PDL-OP).

12. The electronic device (ED) of any one of claims 3 to 11,
wherein a portion of the second optical layer (INL) is disposed in the openings (PV-OP) and is in contact with the encapsulation layer (TFE) which is exposed from the first patterns (PV-1), the second pattern (PV-2), and the third pattern (PV-3); and/or
wherein the passivation layer (PVP), the first patterns (PV-1), the second pattern (PV-2), and the third pattern (PV-3) have a same thickness.

13. The electronic device (ED) of any one of claim 2 to 12, wherein the first optical layer (PVX) and the second optical layer (INL) comprise different respective organic materials; and/or have different respective refractive indices, wherein the first optical layer (PVX) has preferably a refractive index of about 1.45 to about 1.55, and the second optical layer (INL) has preferably a refractive index of about 1.60 to about 1.70.

14. The electronic device (ED) of any one of the preceding claims, wherein:
the display panel (DP) further comprises a dummy region (CP) surrounded by the third region (AA3) and a transmission region (CA) surrounded by the dummy region (CP),
dummy unit pixels (PXU-P) comprising the pixels (PX) and a dummy IR emitter (IR-D) are disposed in the dummy region (CP), and
transmission unit pixels (PXU-A) comprising the pixels (PX) are disposed in the transmission region (CA).

15. The electronic device (ED) of claim 14,
wherein the dummy IR emitter (IR-D) and the IR emitter (IR) have the same structure, and
the light-emitting element (LED, OLED) comprised in the dummy emitter (IR-D) is not connected to a transistor (TR) comprised in the dummy emitter (IR-D); and/or
wherein the pixels (PX) disposed in the unit pixels (PXU), the dummy unit pixels (PXU-P), and the transmission unit pixels (PXU-A) have the same arrangement structure.
